# EUROPÄISCHE PATENTSCHRIFT

(11) **EP 0 900 480 B1**
(45) Veröffentlichungstag und Bekanntmachung des Hinweises auf die Patenterteilung: **11.07.2001**
(21) Anmeldenummer: 97923091.9
(22) Anmeldetag: 15.05.1997
(51) Int. Cl.: H03K 17/96

(54) **STEUERSCHALTUNG ZUR REGISTRIERUNG DER BETÄTIGUNG EINER OPTISCHEN TASTE**
CONTROL CIRCUIT FOR RECORDING THE ACTUATION OF AN OPTICAL KEY
CIRCUIT DE COMMANDE POUR ENREGISTRER L'ACTIONNEMENT D'UNE TOUCHE OPTIQUE

(30) Priorität: 23.05.1996 DE 19620866
(43) Veröffentlichungstag der Anmeldung: 10.03.1999
(73) Patentinhaber: Ziegler, Horst Prof. Dr., D-33100 Paderborn (DE)
(72) Erfinder: Ziegler, Horst Prof. Dr., D-33100 Paderborn (DE)
(74) Vertreter: Tiesmeyer, Johannes, Dr.
(86) Internationale Anmeldenummer: EP9702508
(87) Internationale Veröffentlichungsnummer: WO9744902

(56) Entgegenhaltungen:
- EP-A- 0 172 405
- EP-A- 0 387 630
- EP-A- 0 651 509
- US-A- 4 454 423
- PATENT ABSTRACTS OF JAPAN vol. 007, no. 023 (P-171), 29.Januar 1983 & JP 57 178117 A (MINOLTA CAMERA KK), 2.November 1982,

## Beschreibung

Die Erfindung betrifft eine Steuerschaltung zur Registrierung der Betätigung einer optischen Taste, bei der eine im Leerlauf-Spannungsgeneratormodus betriebene, lichtempfindliche Diode als Tastenbetätigungssensor einer lichtdurchlässigen und von einem Finger gegen Lichteintritt von außen abschattbaren Tastenfläche zugeordnet ist, wobei die Steuerschaltung eine Mikroprozessorschaltung mit Spannungsüberwachungsmitteln zur Überwachung der Leerlaufspannung der Diode aufweist, und wobei die Mikroprozessorschaltung dazu eingerichtet ist, die von den Spannungsüberwachungsmitteln bereitgestellten Informationen über die Leerlaufspannung der Diode auszuwerten, um eine Betätigung der optischen Taste von Helligkeitsschwankungen des Umgebungslichtes zu unterscheiden,

Zum Stand der Technik nach dem Oberbegriff des Anspruchs 1 wird auf die DE 43 36 669 C1 oder die EP-A-0 651 509 verwiesen, welche ein Eingabefeld mit "logarithmischen optischen Tasten" betreffen.

Bei dem Eingabefeld sind einzelnen Betätigungsflächen optoelektronische Betätigungssensoren zugeordnet, welche auf Helligkeitsänderungen ansprechen, die beim Aufsetzen eines Fingers auf eine Betätigungsfläche eintreten. Als optische Betätigungssensoren werden Photodioden oder Leuchtdioden verwendet, die im Leerlauf als Photoelemente betrieben werden. Die Dioden erzeugen eine Ausgangsspannung (Leerlaufspannung), die in Abhängigkeit von dem auf sie auffallenden Lichtstrom in etwa logarithmisch zunimmt. Derartige Betätigungssensoren liefern daher ein Ausgangssignal, dessen Amplitude sich mit Änderungen in der auffallenden Lichtintensität nur verhältnismäßig wenig ändert. Damit führen auch starke Änderungen in der Umgebungshelligkeit nicht zu großen Änderungen im Ausgangssignal. Es ist damit möglich, daß bei rascher Änderung in der Helligkeit des auffallenden Lichtes, wie sie typischerweise beim Aufsetzen eines Fingers auf die Betätigungsfläche erhalten wird, eine stärkere zeitliche Änderung im Ausgangssignal des zugeordneten Betätigungssensors erhalten wird, als bei demgegenüber starker, jedoch über einen größeren Zeitraum verteilter Änderung der Beleuchtungsstärke. Eine mit den Dioden verbundene Auswerteeinheit besorgt die entsprechende Unterscheidung zwischen raschen Änderungen auch kleiner Amplitude von langsamen Änderungen großer Amplitude, um eine Tastenbetätigung von Schwankungen der Umgebungshelligkeit unterscheiden zu können.

Aus der EP-A-O 172 405 ist eine Schaltung für ein transportables Teststreifen-Leseinstrument offenbart, die einen Analog/Digital-Wandler aufweist, um die vom Lichteinfall abhängige Photospannung einer Photodiode zu messen und als digitalen Messwert zu repräsentieren. Bei dem Analog/Digital-Wandler handelt es sich um einen modifizierten Dual-Slope-Wandler mit einem Eingangsverstärker und einem daran angeschlossenen Integrationskondensator, einer Referenzstromquelle und einem Komparator. Der Ausgang des Komparators ist an einem Portanschluss eines Mikroprozessors angeschlossen. Bei der Durchführung eines A/D-Wandlungsschrittes erfolgt zunächst über ein vorbestimmtes Zeitintervall die Integration der Eingangsspannung, also der Photodiodenspannung, so dass der Integrationskondensator seinen Ladezustand entsprechend ändert. Nach Ablauf dieses vorbestimmten Zeitintervalls erfolgt die Integration der Referenzspannung mit umgekehrtem Vorzeichen, so dass der ursprüngliche Ladezustand des Integrationskondensators wiederhergestellt wird. Während dieses Schrittes der Integration der Referenzspannung erfolgt eine Zeitmessung bzw. Zählung der Impulse eines periodischen Impulssignals mittels des Mikroprozessors, wobei der das Erreichen des ursprünglichen Ladezustandes des Integrationskondensators überwachende Komparator als Stopp-Signalgeber für die Zeitmessung dient. Die zur Erfassung der Photodiodenspannung und A/D-Wandlung gemäß EP-A-0 172 405 erforderliche zusätzliche Beschaltung des Mikroprozessors umfasst aktive elektronische Bauelemente und ist vergleichsweise aufwendig. Die Übertragung der A/D-Wandlerschaltung gemäß EP-A-0 172 405 auf eine gattungsgemäße Steuerschaltung zur Registrierung der Betätigung einer optischen Taste würde somit keine Schaltungsvereinfachung mit sich bringen.

Der Erfindung liegt die Aufgabe zugrunde, eine Steuerschaltung der in der EP-A-0651509 beschriebenen Art bereitzustellen, die mit geringem Schaltungsaufwand realisierbar ist und zuverlässig funktioniert.

Zur Lösung der Aufgabe wird ausgehend von einer Steuerschaltung mit den Merkmalen des Oberbegriffs des Anspruchs 1 vorgeschlagen, dass die Steuerschaltung einen mit der Diode verbundenen Kondensator und einen an einem Verbindungspunkt zwischen der Diode und dem Kondensator angeschlossenen Widerstand aufweist, wobei die Diode anodenseitig mit einem ersten Ausgangsport (Anschluss B) der Mikroprozessorschaltung - und kathodenseitig über den Widerstand mit einem zweiten Ausgangsport (Anschluss C) der Mikroprozessorschaltung - sowie über den Kondensator mit einem H-Potential führenden Anschluss (D) verbunden ist, dass die Mikroprozessorschaltung einen mit dem Verbindungspunkt zwischen der Diode und dem Kondensator verbundenen hochohmigen Eingangsport (Anschluss A) zur Spannungsüberwachung aufweist und dass die Steuerschaltung dazu eingerichtet ist, die Ausgangsports (Anschluss B, Anschluss C) in zwei aufeinander folgenden Schritten in der Weise zu steuern, dass bei dem ersten Schritt der erste Ausgangsport (Anschluss B) H-Potential führt und der zweite Ausgangsport (Anschluss C) in einen hochohmigen Tri-State-Zustand geschaltet ist, so dass der Kondensator einen der Leerlaufspannung der Diode entsprechenden Ladezustand annimmt, wohingegen bei dem zweiten Schritt der erste Ausgangsport (Anschluss B) in einen hochohmigen Tri-State-Zustand geschaltet ist und der zweite Ausgangsport (Anschluss C) L-Potential führt, so dass sich der Ladezustand des Kondensators ändert und die Spannung an dem Eingangsport (A) sinkt, wobei die Steuerschaltung dazu eingerichtet ist, als Maß für die Leerlaufspannung der Diode die Zeit zu messen, die im zweiten Schritt vergeht, bis die Spannung am Eingangsport (A) auf eine vorbestimmte Schaltschwellspannung des Eingangsports (A) abgesunken ist.

Die Schaltschwellspannung des Eingangsports ist die Spannung, deren Unterschreiten die Mikroprozessorschaltung als Übergang von logisch 1 nach logisch 0 interpretiert.

Die Diode ist zweckmäßigerweise in einem Gehäuse mit einer zur Diode hin lichtdurchlässigen Gehäuseöffnung angeordnet, die einer Tastenfläche für manuelle Dateneingabe zugeordnet ist, wobei die Diode als Photoelement wirksam ist und die Steuerschaltung die von der Intensität des von der Diode empfangenen Lichtes abhängige Leerlaufspannung der Diode erfaßt, um eine den Lichtdurchlaß zur Diode verändernde plötzliche Abschattung der Gehäuseöffnung als manuellen Dateneingabevorgang zu registrieren.

Die Diode dient als logarithmische optische Taste, wie sie vom Grundprinzip her aus der DE 43 36 669 C1 und der EP-A-0651509 bekannt ist.

Die erfindungsgemäße Steuerschaltung zur Registrierung der Betätigung einer optischen Taste zeichnet sich insbesondere durch das sehr einfache Spannungs-Zeit-Wandlungsverfahren zur Überwachung der Leerlaufspannung der Diode und somit zur Überwachung der Tastenbetätigung aus, wobei die erfindungsgemäße Steuerschaltung mit geringem schaltungstechnischen Aufwand auskommt.

Die Erfindung wird nachstehend anhand von Ausführungsbeispielen unter Bezugnahme auf die Figuren näher erläutert.
- Fig. 1a: zeigt ein teils in Blockdarstellung gezeichnetes Schaltbild eines ersten Ausführungsbeispiels einer auch als Datensende- und - empfangsschaltung betreibbaren Steuerschaltung nach der Erfindung.
- Fig. 1b: ist eine Zustandstabelle, aus der ersichtlich ist, wie bestimmte Anschlüsse der Steuerschaltung von einer Mikroprozessorschaltung aus in verschiedenen Betriebszuständen angesteuert werden.
- Fig. 1c: ist ein Spannungs-Zeit-Diagramm zur Erläuterung der Betriebsweise der Schaltung nach Fig. 1a in einem Tasteneingabebetriebsmodus.
- Fig. 2: zeigt eine Variante der Steuerschaltung nach Fig. 1a.
- Fig. 3: illustriert ein konkretes Anwendungsbeispiel für eine Datensende- und -empfangsschaltung mit einer Steuerschaltung nach der Erfindung.

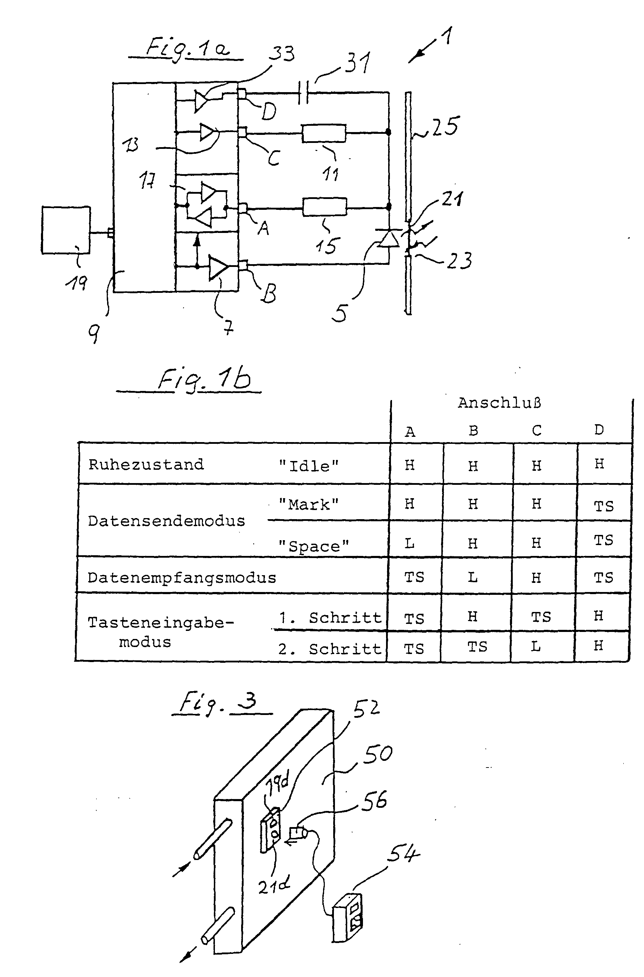

In Fig. 1a ist ein teils in Blockdarstellung gezeichnetes Schaltbild eines ersten Ausführungsbeispiels einer als Datensende- und -empfangsschaltung betreibbaren Steuerschaltung nach der Erfindung dargestellt.

Die Datensende- und -empfangsschaltung 1 enthält für den optischen Datenaustausch mit einem in Fig. 1a nicht gezeigten Gerät eine herkömmliche Infrarot-Leuchtdiode 5, die in der Datensende- und -empfangsschaltung 1 sowohl zum Senden - als auch zum Empfangen optischer Daten im Halbduplex-Betrieb genutzt wird.

Die Leuchtdiode 5 ist mit ihrer Anode an einem Ausgangsport 7 einer Mikroprozessorschaltung 9 angeschlossen.

Die Kathode der Leuchtdiode 5 ist über einen ersten Widerstand 11 von beispielsweise 1,5 MΩ mit einem im optischen Datensendemodus und im optischen Datenempfangsmodus H-Potential führenden Ausgangsport 13 der Mikroprozessorschaltung 9 - und über einen zweiten Widerstand 15 von beispielsweise 680 Q mit einem bidirektionalen Datenübertragungsport 17 der Mikroprozessorschaltung 9 verbunden.

Der Ausgangsport 13 ist von der Mikroprozessorschaltung 9 in einen hochohmigen Tri-state-Zustand schaltbar, so daß der Ausgang 13 in diesem Zustand quasi elektrisch abgeschaltet ist.

Die Datensende- und -empfangsschaltung 1 ist zur asynchronen, bitseriellen Datenübertragung im Halbduplexbetrieb eingerichtet, wobei die Mikroprozessorschaltung 9 den Datensende- und -empfangsbetrieb gemäß einem Standardprotokoll für serielle Datenübertragung steuert.

In Fig. 1b ist eine Tabelle gezeigt, in der die elektrischen Zustände bzw. Pegel der Anschlüsse A, B, C, D in Abhängigkeit vom momentanen Betriebszustand der Datensende- und -empfangsschaltung 1 nach Fig. 1a dargestellt sind.

Im Datensendemodus steuert die Mikroprozessorschaltung 9 den Ausgangsport 7 derart an, daß der Anschluß B H-Pegel führt. Über den Anschluß A des Datenübertragungsports 17 gibt die Mikroprozessorschaltung 9 dann entsprechend dem zu sendenden Signal eine Bitfolge aus, wobei der Pegel am Anschluß A entsprechend der Bitfolge zwischen H (= "Mark") und L (= "Space") wechselt. Dies führt zu einer entsprechenden Modulation der Helligkeit der Leuchtdiode 5, wobei die Leuchtdiode 5 in Flußrichtung betrieben wird und entsprechend aufleuchtet, wenn am Ausgang A L-Pegel vorliegt, wohingegen die Leuchtdiode 5 erlischt, wenn am Ausgang A H-Pegel vorliegt. Die Leuchtdiode 5 sendet somit ein optisches Datensignal aus, das der über den Ausgang A der Mikroprozessorschaltung 9 abgegebenen Bitfolge entspricht.

Das von der Leuchtdiode 5 abgegebene Signal wird im Beispiel der Figur 1a von einem (nicht gezeigten) zweiten Gerät empfangen, welches als Kommunikationspartner der Datensende- und -empfangsschaltung 1 nach einem entsprechenden Datenübertragungsprotokoll arbeitet.

Zum Einschalten des Datenempfangsmodus steuert die Mikroprozessorschaltung 9 die Anode der Leuchtdiode 5 über den Anschluß B des Ports 7 mit L-Pegel an, um die kathodenseitig über den ersten Widerstand 11 mit H-Potential verbundene Leuchtdiode 5 in Sperrichtung vorzuspannen, und der mit einem Tri-State-Buffer ausgestattete bidirektionale Datenübertragungsport 17 wird von der Mikroprozessorschaltung 9 auf Datenempfang umgeschaltet, wobei der Anschluß A nunmehr einen sehr hochohmigen Eingangsanschluß bildet.

Der Vorwiderstand 11 hat einen vergleichsweise großen Widerstandswert von beispielsweise 1,5 MΩ. Die im Datenempfangsmodus von der Mikroprozessorschaltung 9 als Photodiode betriebene Leuchtdiode 5 weist in Sperrichtung einen (sehr kleinen) Sperrstrom auf, der stark von der Intensität des zur Leuchtdiode einfallenden Lichtes abhängt. Bei Empfang eines optischen Datensignals in Form einer Hell/Dunkel-Bitfolge wird der Sperrstrom der Diode 5 entsprechend moduliert, so daß an dem hochohmigen Anschluß A des bidirektionalen Datenübertragungsports 17, der über den zweiten Widerstand 15 mit der Kathode der Diode 5 verbunden ist, ein entsprechendes elektrisches Datensignal erscheint, welches von der Mikroprozessorschaltung 9 als Empfangsdatensignal registriert wird.

Das als optischer Kommunikationspartner der Datensende- und -empfangsschaltung 1 verwendete Gerät kann ebenfalls mit einer Datensende- und -empfangsschaltung ausgestattet sein, wie sie in Fig. 1a mit 1 gekennzeichnet ist. Alternativ könnte ein betreffendes Gerät jedoch in konventioneller Weise mit gesonderten optischen Elementen für die Sendung und für den Empfang optischer Datensignale versehen sein.

Die Leuchtdiode 5 wird nicht nur zur bidirektionalen gelegentlichen Datenkommunikation, sondern in einem Multiplex-Betrieb auch als Betätigungssensor einer sog. logarithmischen optischen Taste verwendet, wie sie an sich aus dem deutschen Patent DE 43 36 669 C1 bekannt ist. Eine solche Taste kann beispielsweise dazu dienen, eine bestimmte Anzeigebetriebsart einer an der Mikroprozessorschaltung 9 angeschlossenen Datenanzeigeeinrichtung 19 durch manuelle Bedienung der Taste einzuschalten.

Manuelle Bedienung der Taste bedeutet bei dem Ausführungsbeispiel nach der Fig. 1, daß eine Bedienungsperson das bei 21 angedeutete, zur Diode 5 hin lichtdurchlässige Fenster in der Bedienungsfläche 23 mit dem Finger abschattet. Die Bedienungsfläche 23 befindet sich an der bei 25 angedeuteten Gehäusewand.

Zusätzlich zu den Betriebsarten Daten senden und Daten empfangen, wie sie unter Bezugnahme auf Fig. 1a und Fig. 1b bereits beschrieben worden sind, weist die Schaltung nach Fig. 1a einen Tasteneingabemodus auf, in dem die Leuchtdiode 5 im Leerlauf betrieben und ihre Leerlaufspannung detektiert wird, die näherungsweise proportional zum Logarithmus der Intensität des in die Leuchtdiode einfallenden Lichtes ist.

Die Messung der Leerlaufspannung der Diode 5b erfolgt erfindungsgemäß nach einem einfachen Spannungs-Zeit-Wandlungsverfahren. Dabei wird im Tasteneingabemodus in einem ersten Schritt ein Kondensator 31 von der im Leerlauf-Spannungsgenerator-Modus betriebenen Leuchtdiode 5 in einigen ms entsprechend der Diodenleerlaufspannung geladen. In einem zweiten Schritt wird der Ladezustand des Kondensators 31 geändert und dabei die Zeit gemessen, bis die an dem diodenseitigen Anschluß des Kondensators abzugreifende Spannung eine vorbestimmte Schaltschwelle unterschreitet.

Gemäß Fig. 1a ist der betreffende Kondensator 31 zwischen der Kathode der Leuchtdiode 5 und dem Anschluß D eines Tri-state-Ausgangsports 33 der Steuerschaltung 9 geschaltet.

Die Mikroprozessorschaltung 9 steuert die verschiedenen Betriebszustände der Datensende- und -empfangsschaltung in einem Multiplexbetrieb.

Gemäß der Zustandstabelle Fig. 1 b ist der Anschluß D des Ports 33 sowohl im Datensendemodus als auch im Datenempfangsmodus im extrem hochohmigen Tri-state-Zustand TS. In bezug auf die äußere Beschaltung der Mikroprozessorschaltung 9 bedeutet dies, daß der Ausgangsport 33 elektrisch abgeschaltet ist. Die übrigen Anschlüsse A, B und C werden im Datensendemodus und im Datenempfangsmodus von der Mikroprozessorschaltung 9 wie bereits erwähnt angesteuert, wobei der Kondensator 31 in Fig. 1 a den Datensende- und -empfangsbetrieb nicht beeinträchtigt, da der Anschluß D elektrisch abgeschaltet ist.

Wie bereits angedeutet, ist der Tasteneingabemodus in zwei Schritte unterteilt. Dies sind die Schritte "Kondensator laden " und "Kondensatorladezustand ändern sowie Zeit messen".

Im ersten Schritt sind die Anschlüsse A und C im hochohmigen Tri-state-Zustand TS, wohingegen die Anschlüsse B und D H-Pegel aufweisen, so daß die Diode 5 in den Leerlauf-Spannungsgenerator-Modus geschaltet ist. Die Diode 5 lädt nun den Kondensator 31 auf ihre von der Intensität des einfallenden Lichtes abhängige Leerlaufspannung auf, die auf H-Potential (Vcc) bezogen ist (Anschlüsse B und D an H-Potential).

In Fig. 1 c ist der am Anschluß A des bidirektionalen Datenübertragungsports 17 zu registrierende zeitliche Spannungsverlauf in einem Spannungs-Zeit-Diagramm für den Kondensatorladeschritt und den noch zu erläuternden Ladezustandsänderungsschritt qualitativ dargestellt.

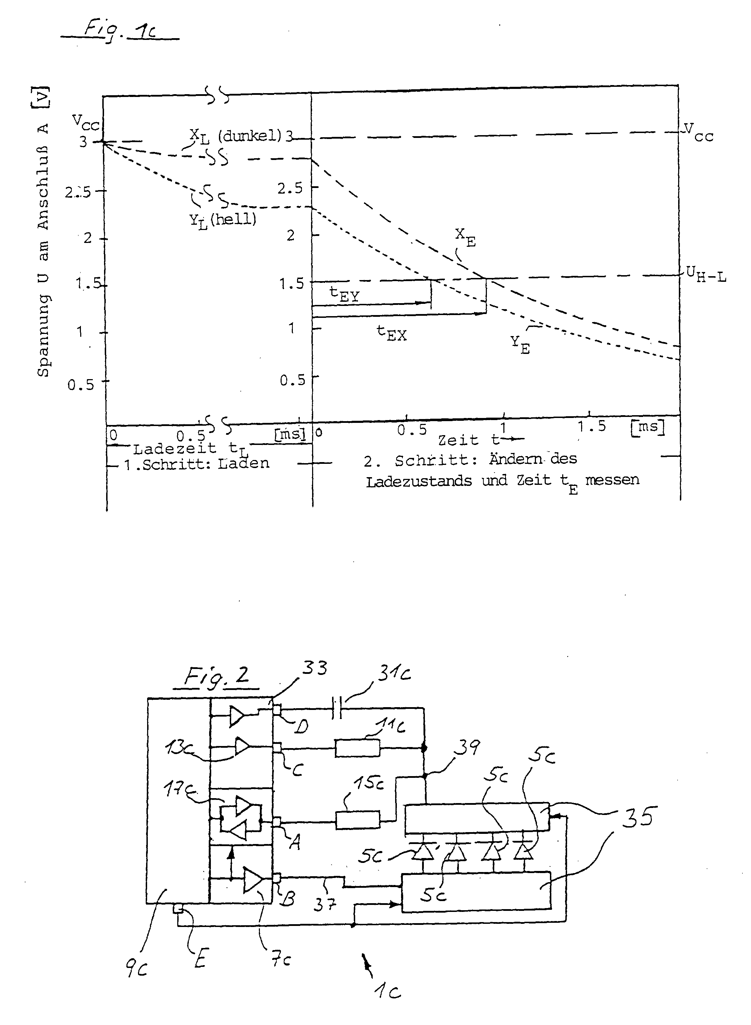

Die Kurve X_{L} in Fig. 3c zeigt den Spannungsverlauf am Anschluß A für den Fall, daß wenig Licht zu der als Photoelement wirksamen Diode 5 gelangt, wie dies der Fall ist, wenn das Fenster 21 der Bedienungsfläche 23 von einem Finger abgeschattet wird. Die Kurve Y_{L} gibt den Spannungsverlauf am Anschluß A für den Fall an, daß eine größere Lichtmenge zur Diode 5 gelangt, wie dies normalerweise der Fall ist, wenn das Fenster 21 nicht von außen abgeschattet ist.

Die sich nach Ablauf der vorbestimmten Ladezeit t_{L} am Anschluß A einstellende Spannung U entspricht dem Wert (Vcc - U_{D}), wobei Vcc die H-Pegel-Spannung (Betriebsspannung) und U_{D} die vom Lichteinfall in die Diode abhängige Diodenleerlaufspannung bezeichnet. Im Falle geringeren Lichteinfalls (Kurve X_{L}) ist die Leerlaufspannung U_{D} kleiner als im Falle stärkeren Lichteinfalls (Kurve Y_{L}), so daß bezogen auf Masse bzw. L-Potential die Spannung am Anschluß A nach Ablauf der Ladezeit t_{L} im Falle schwächeren Lichteinfalls größer ist als im Falle stärkeren Lichteinfalls.

Die Mikroprozessorschaltung 9 beendet den Kondensatorladeschritt bei Ablauf der vorbestimmten Zeit t_{L}, indem sie den Ausgangsport 7 (Anschluß B) in den hochohmigen Tri-state-Zustand TS umschaltet und den Anschluß C in den L-Pegel-Zustand versetzt. Hiermit ist dann der Schritt der Änderung des Ladezustandes eingeleitet, wobei ein Stromfluß von dem diodenseitigen Anschluß des Kondensators 31 über den hochohmigen ersten Widerstand 1 1 zu dem Anschluß C (Masse) erfolgt. Die Mikroprozessorschaltung 9 mißt die Zeit t_{E}, die vergeht, bis die Spannung am Anschluß A auf die Schaltschwellspannung des im hochohmigen TS-Empfangszustand befindlichen Ports 17 abgesunken ist. Der Schaltschwellpegel des Ports 17 ist in Fig. 1c mit U_{H-L} gekennzeichnet. Unterschreitet die Spannung am Anschluß A diesen Pegel, so interpretiert die Mikroprozessorschaltung 9 dies als Übergang von H nach L (logisch 1 nach 0).

Der Verlauf der Spannung am Anschluß A während des Schrittes der Änderung des Ladzustandes des Kondensators ist in Fig. 1 c durch die Kurve X_{E} für den Fall schwachen Lichteinfalls (optische Taste betätigt) - und durch die Kurve Y_{E} für den Fall stärkeren Lichteinfalls (optische Taste nicht betätigt) dargestellt.

Die Spannungsänderungskurve X_{E} bzw. Y_{E} folgt in sehr guter Näherung der Beziehung U(t) = (Vcc - U_{D}) x exp(-t/*T*).

Darin bezeichnet;
- U(t): die Spannung am Anschluß A
Vcc die H-Pegel-Spannung
U_{D} die Diodenleerlaufspannung
*T* die Zeitkonstante.

Mit einem Kondensator 31 mit einer Kapazität von 1nF und einem 1,5 MΩ-Widerstand 11 ergibt sich für die Zeitkonstante T der Wert 1,5 ms.

Wie in Fig. 1c deutlich zu erkennen ist, unterschreitet die Kurve Y_{E} die Schaltschwellspannung U_{H-L} früher als die Kurve X_{E}, so daß die Mikroprozessorschaltung 9 anhand der Zeitmessung indirekt Informationen über den Belichtungszustand der Diode 5 erhält. Da es bei der logarithmischen optischen Taste nur auf relativ schnelle Änderungen (<1 s) und nicht auf die Absolutwerte der Photospannung (Leerlaufspannung) der Diode 5 ankommt, ist diese sehr einfache Spannungs-Zeit-Wandlung für die Zwecke der Unterscheidung der Zustände "Taste betätigt" und "Taste nicht betätigt" vollkommen ausreichend.

Stellt die Mikroprozessorschaltung 9 nun bei zwei aufeinander folgenden Meßzyklen fest, daß die Zeit t_{E} bis zum Unterschreiten von U_{H-L} beim zuletzt durchgeführten Meßzyklus länger war als beim vorausgehenden Meßzyklus, und zwar um eine Mindestdifferenz zum vorausgehenden Meßzyklus, so interpretiert sie dies als Betätigung der Taste 21, 23 und schaltet den Anzeigemodus der Digitalanzeigeeinrichtung 19 um.

Das vorstehend beschriebene Prinzip der Realisierung und der Überwachung einer logarithmischen optischen Taste kann auf ein optisches Tastenfeld mit mehreren Tasten ausgedehnt werden, wie dies schematisch in Fig. 2 angedeutet ist.

Das Ausführungsbeispiel nach Fig. 2 unterscheidet sich von dem nach Fig. 1a dadurch, daß anstelle einer Leuchtdiode 5 mehrere Leuchtdioden 5c vorgesehen sind, deren jede einer gesonderten optischen Taste eines (nicht gezeigten) Tastenbedienungsfeldes zugeordnet ist. Mit 35 ist in Fig. 2 eine Multiplexereinrichtung bezeichnet, die von der Mikroprozessorschaltung 9c über ein am Ausgang E abgegebenes Steuersignal derart angesteuert wird, daß sie selektiv jeweils eine der Leuchtdioden 5c anodenseitig mit der an dem Ausgangsanschluß B der Mikroprozessorschaltung 9c angeschlossenen Verbindungsleitung 37 und kathodenseitig mit dem Verbindungspunkt 39 des Kondensators 31c und der Widerstände 11c, 15c verbindet. Die Schaltung nach Fig. 2 arbeitet in bezug auf die jeweils in den Meßbetrieb einbezogene Diode 5c wie in dem Ausführungsbeispiel nach Fig. 1a. Die "Abfrage" der einzelnen Dioden 5c erfolgt in regelmäßigen Zeitabständen zyklisch.

Wenngleich bei dem Ausführungsbeispiel nach Fig. 2 jede der Leuchtdioden 5c sowohl als logarithmische optische Taste als auch als optisches Sende- und Empfangselement in der beschriebenen Weise verwendet werden kann, so kann es im Rahmen der Erfindung bei einer Schaltung nach Fig. 2 alternativ vorgesehen sein, daß die Dioden 5c ausschließlich als Betätigungssensoren für optische Tasten verwendet werden. In diesem Fall kann der Datensendemodus und der Datenempfangsmodus entfallen, so daß die Schaltung lediglich als Tastatursteuerung ausgebildet ist.

In Fig. 3 ist ein Anwendungsbeispiel für eine Datensende- und -empfangsschaltung der vorstehend beschriebenen Art illustriert. Gezeigt ist ein an einem Heizkörper 50 ortsfest montiertes elektronisches Verbrauchsmeßgerät (Heizkostenverteiler) 52 mit einer Infrarot-Optokommunikationsschnittstelle in Form einer Datensende- und -empfangsschaltung, wobei über die OptokommunikationsschnittstelleHeizkörper-Verbrauchsmeßdatenausdem Verbrauchsmeßgerät 52 ausgelesen werden können. Hierzu ist ein transportables Auslesegerät 54 mit einem Optokopf 56 vorgesehen, der beispielsweise einen Phototransistor als optisches Empfangselement und eine Leuchtdiode als optisches Sendeelement zur Kommunikation mit dem Gerät 52 aufweist. Zur Datenübertragung zwischen der Optokommunikationsschnittstelle des Gerätes 52 und dem Optokopf 56 wird letzterer an das Fenster 21d des Gerätes 52 herangeführt, wobei hinter dem Fenster 21d die Leuchtdiode der Datensende- und -empfangsschaltung angeordnet ist. Es ist auch möglich, Daten vom Auslesegerät 54 über den Optokopf 56 zum Verbrauchsmeßgerät 52 hin zu übertragen, beispielsweise Auslesezeitpunkte und/oder Parameterwerte, die die Heizkörperklasse und dgl. spezifizieren und in dem Gerät 52 gespeichert werden. Die Mikroprozessorschaltung der Datensende- und -empfangsschaltung in dem Gerät 52 übernimmt auch Aufgaben bezüglich der Verbrauchsmessung - und Meßwertauswertung.

Die Digitalanzeigeeinrichtung 19d des Geräts 52 kann zwischen mehreren Anzeigebetriebsarten manuell umgeschaltet werden. Hierzu dient die Leuchtdiode hinter dem Fenster 21d des Gerätes 52 dann als Tastenbetätigungssensor in der bereits beschriebenen Weise. Tastenbetätigung in diesem Sinne liegt vor, wenn das Fenster 21d beispielsweise mit einem Finger abgeschattet wird.

In einer dem Ausführungsbeispiel nach Fig. 3 ähnlichen Weise kann eine Datensende- und -empfangsschaltung der beschriebenen Art beispielsweise auch bei anderen elektronischen Verbrauchszählern, beispielsweise Wasserzählern, Wärmemengenzählern, Gaszählern, Stromzählern usw., Verwendung finden. Diese Aufzählung ist keinesfalls abschließend.

## Patentansprüche

1. Steuerschaltung zur Registrierung der Betätigung einer optischen Taste, bei der eine im Leerlauf-Spannungsgeneratormodus betriebene, lichtempfindliche Diode (5; 5c) als Tastenbetätigungssensor einer lichtdurchlässigen und von einem Finger gegen Lichteintritt von außen abschattbaren Tastenfläche (21, 23) zugeordnet ist, wobei die Steuerschaltung eine Mikroprozessorschaltung (9; 9c) mit Spannungsüberwachungsmitteln zur Überwachung der Leerlaufspannung der Diode (5; 5c) aufweist, und wobei die Mikroprozessorschaltung (9; 9c) dazu eingerichtet ist, die von den Spannungsüberwachungsmitteln bereitgestellten Informationen über die Leerlaufspannung der Diode (5; 5c) auszuwerten, um eine Betätigung der optischen Taste von Helligkeitsschwankungen des Umgebungslichtes zu unterscheiden,
dadurch gekennzeichnet,
dass die Steuerschaltung einen mit der Diode (5; 5c) verbundenen Kondensator (31; 31c) und einen an einem Verbindungspunkt zwischen der Diode (5; 5c) und dem Kondensator (31; 31c) angeschlossenen Widerstand (11; 11c) aufweist,
wobei die Diode (5; 5c) anodenseitig mit einem ersten Ausgangsport (B) der Mikroprozessorschaltung - und kathodenseitig über den Widerstand (11; 11c) mit einem zweiten Ausgangsport (C) der Mikroprozessorschaltung - sowie über den Kondensator (31; 31c) mit einem H-Potential führenden Anschluss (D) verbunden ist,
dass die Mikroprozessorschaltung einen mit dem Verbindungspunkt zwischen der Diode (5; 5c) und dem Kondensator (31; 31c) verbundenen hochohmigen Eingangsport (A) zur Spannungsüberwachung aufweist und
dass die Steuerschaltung dazu eingerichtet ist, die Ausgangsports (B, C) in zwei aufeinander folgenden Schritten in der Weise zu steuern,
dass bei dem ersten Schritt der erste Ausgangsport (B) H-Potential führt und der zweite Ausgangsport (C) in einen hochohmigen Tri-State-Zustand geschaltet ist, so dass der Kondensator (31; 31c) einen der Leerlaufspannung der Diode (5; 5c) entsprechenden Ladezustand annimmt,
wohingegen bei dem zweiten Schritt der erste Ausgangsport (B) in einen hochohmigen Tri-State-Zustand geschaltet ist und der zweite Ausgangsport (C) L-Potential führt, so dass sich der Ladezustand des Kondensators ändert und die Spannung an dem Eingangsport (A) sinkt,
wobei die Steuerschaltung dazu eingerichtet ist, als Maß für die Leerlaufspannung der Diode (5; 5c) die Zeit zu messen, die im zweiten Schritt vergeht, bis die Spannung am Eingangsport (A) auf eine vorbestimmte Schaltschwellspannung des Eingangsports (A) abgesunken ist.

## Claims

1. Control circuit for recording the actuation of an optical key, in which a light-sensitive diode (5; 5c) operated in open circuit mode as key actuation sensor is associated with a lightpermeable touch area (21, 23) which can be blocked by a finger against light from outside, wherein the control circuit has a microprocessor circuit (9; 9c) with voltage monitoring means for monitoring the no-load voltage of the diode (5; 5c), and wherein the microprocessor circuit (9; 9c) is equipped to evaluate the information about the no-load voltage of the diode (5; 5c) provided by the voltage monitoring means in order to differentiate an actuation of the optical key from variations in the brightness of the ambient light, characterised in that the control switch has a capacitor (31; 31c) connected to the diode (5; 5c) and a resistor (11; 11c) connected to a connection point between the diode (5; 5c) and the capacitor (31; 31c), wherein the diode (5; 5c) is connected at the anode side to a first output port (B) of the microprocessor circuit and at the cathode side to a second output port (C) of the microprocessor circuit via the resistor (11; 11c) and to a high potential terminal connection (D) via the capacitor (31; 31c), in that the microprocessor circuit has a high-resistance input port (A) connected to the connection point between the diode (5; 5c) and the capacitor (31; 31c) to monitor the voltage and, in that the control circuit is equipped to control the output ports (B, C) in two successive stages in such a manner that in the first stage the first output port (B) supplies high potential and the second output port (C) is connected in a high-resistance tristate condition, so the capacitor (31; 31c) assumes a charge state corresponding to the no-load voltage of the diode (5; 5c), whereas in the second stage the first output port (B) is connected in a high-resistance tristate condition and the second output port (C) supplies low potential, so the charge state of the capacitor changes and the voltage at the input port (A) decreases, wherein the control circuit is equipped to measure, as a measure of the no-load voltage of the diode (5; 5c), the time elapsing in the second stage until the voltage at the input port (A) has decreased to a predetermined input port (A) switching threshold.

## Revendications

1. Circuit de commande pour l'enregistrement de l'actionnement d'une touche optique, dans lequel une diode (5; 5c) sensible à la lumière et fonctionnant en mode générateur de tension à vide, est affectée, en tant que capteur d'actionnement de touche, à une surface de touche (21, 23) transparente et que l'on peut occulter de l'extérieur contre la pénétration de lumière, au moyen d'un doigt, le circuit de commande comportant un circuit à microprocesseur (9 ; 9c) avec des moyens de surveillance de la tension, pour surveiller la tension à vide de la diode (5 ; 5c), et le circuit à microprocesseur (9 ; 9c) étant aménagé pour exploiter les informations relatives à la tension à vide de la diode (5; 5c), fournies par les moyens de surveillance de la tension, afin de faire la distinction entre un actionnement de la touche optique et des fluctuations de l'intensité de la lumière ambiante,
caractérisé
en ce que le circuit de commande comporte un condensateur (31 ; 31 c) relié à la diode (5 ; 5c) et une résistance (11 ; 11c) raccordée à un point de liaison entre la diode (5 ; 5c) et le condensateur (31 ; 31c),
la diode (5 ; 5c) étant reliée, du côté de l'anode, à un premier port de sortie (B) du circuit à microprocesseur - et du côté de la cathode, par l'intermédiaire de la résistance (11; 11c), à un deuxième port de sortie (C) du circuit à microprocesseur - ainsi qu'à un branchement (D), menant au potentiel (H), par l'intermédiaire du condensateur (31 ; 31c),
en ce que le circuit à microprocesseur comporte un port d'entrée (A) de valeur ohmique élevée, relié au point de liaison entre la diode (5; 5c) et le condensateur (31 ; 31 c), pour la surveillance de la tension et
en ce que le circuit de commande est aménagé pour commander les ports de sortie (B, C) en deux étapes successives de manière que lors de la première étape, le premier port de sortie (B) mène au potentiel (H) et le deuxième port de sortie (C) soit commandé dans un état tri-state de grande valeur ohmique, de manière que le condensateur (31; 31c) prenne un état de charge qui correspond à la tension à vide de la diode (5; 5c),
tandis qu'au cours de la deuxième étape, le premier port de sortie (B) est commandé dans un état tri-state de grande valeur ohmique et le deuxième port de sortie (C) mène au potentiel (L), ce qui fait que l'état de charge du condensateur varie et que la tension diminue au port d'entrée (A),
le circuit de commande étant aménagé pour mesurer, en tant que critère de la tension à vide de la diode (5; 5c), le temps qui s'écoule au cours de la deuxième étape jusqu'à ce que la tension baisse au port d'entrée (A) pour atteindre une tension de seuil prédéterminée de commande du port d'entrée (A).
